(19) Europäisches Patentamt
European Patent Office
Office européen des brevets

(11) EP 4 309 889 A1

# (12) EUROPEAN PATENT APPLICATION
published in accordance with Art. 153(4) EPC

(43) Date of publication:
**24.01.2024 Bulletin 2024/04**

(21) Application number: **21935252.3**

(22) Date of filing: **28.12.2021**

(51) International Patent Classification (IPC):
***B32B 5/18*** (2006.01) ***B32B 9/00*** (2006.01)
***C01B 33/155*** (2006.01) ***C23C 14/06*** (2006.01)
***C23C 14/34*** (2006.01)

(52) Cooperative Patent Classification (CPC):
**B32B 5/18; B32B 9/00; C01B 33/155; C23C 14/06; C23C 14/34**

(86) International application number:
**PCT/JP2021/049011**

(87) International publication number:
**WO 2022/209105 (06.10.2022 Gazette 2022/40)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **30.03.2021 JP 2021058829**

(71) Applicant: **NITTO DENKO CORPORATION**
**Ibaraki-shi**
**Osaka 567-8680 (JP)**

(72) Inventors:
- **MORISHIMA Ryota**
  **Ibaraki-shi, Osaka 567-8680 (JP)**
- **HATTORI Daisuke**
  **Ibaraki-shi, Osaka 567-8680 (JP)**
- **YOSHIKAWA Takahiro**
  **Ibaraki-shi, Osaka 567-8680 (JP)**

(74) Representative: **Hoffmann Eitle**
**Patent- und Rechtsanwälte PartmbB**
**Arabellastraße 30**
**81925 München (DE)**

## (54) OPTICAL LAMINATED BODY, METHOD FOR MANUFACTURING OPTICAL LAMINATED BODY, OPTICAL MEMBER, OPTICAL DEVICE, METHOD FOR MANUFACTURING OPTICAL MEMBER, AND METHOD FOR MANUFACTURING OPTICAL DEVICE

(57) The present invention provides an optical laminate including a void-containing layer in which a pressure-sensitive adhesive, an adhesive, and the like barely permeate a void. In order to achieve the object, an optical laminate (10a) or (10b) of the present invention includes a void-containing layer (12) and a low moisture permeable layer (13) formed on the void-containing layer (12), wherein the low moisture permeable layer (13) includes at least one element selected from the group consisting of metal, metal oxide, silicon, silicon oxide and an organic-inorganic hybrid material, and a moisture vapor transmission rate of the low moisture permeable layer (13) measured by a dish method defined in JIS Z 0208-1976 is 35 g/m$^2$·day or less.

(a)

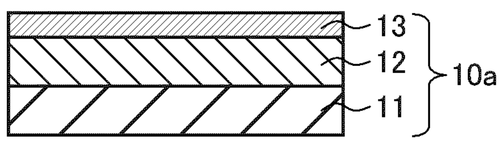


FIG. 1

EP 4 309 889 A1

## Description

TECHNICAL FIELD

The present invention relates to an optical laminate, a method for producing the optical laminate, an optical member, an optical apparatus, a method for producing the optical member, and a method for producing the optical apparatus.

BACKGROUND ART

In an optical device, for example, an air layer having a low refractive index is used as a total reflection layer. Specifically, for example, optical film members (e.g., a light guide plate and a reflector) in a liquid crystal device are laminated with an air layer interposed therebetween. However, when the respective members are separated from each other by an air layer, particularly in a case where the members are large in size, problems such as distortion of the members may arise. In addition, due to trends toward thinner devices, it is desired to integrate the respective members. For this reason, the respective members are integrated by a pressure-sensitive adhesive/adhesive without an air layer interposed therebetween (Patent Literature 1). However, if there is no air layer serving as a total reflection layer, optical characteristics may become poor, which causes light leakage.

Therefore, it has been proposed to use a low refractive index layer instead of an air layer. For example, Patent Literature 2 describes a structure in which a light guide plate and a reflector are laminated with a layer having a lower refractive index than that of the light guide plate interposed therebetween. As the low refractive index layer, for example, a void-containing layer having voids is used in order to make the refractive index low as close as possible to air.

Further, it has been proposed to integrally structure the void-containing layer and a pressure-sensitive adhesive/adhesive layer, in order to introduce the void-containing layer into a device. (Patent Literature 3)

Citation List

Patent Literature

Patent Literature 1: JP 2012-156082 A
Patent Literature 2: JPH10(1998)-62626 A
Patent Literature 3: JP 2014-46518 A

SUMMARY OF INVENTION

Technical Problem

However, when the pressure-sensitive adhesive/adhesive layer or the like is directly formed on the void-containing layer, a void fraction of the void-containing layer may be degraded, due to the pressure-sensitive adhesive, the adhesive and the like permeating inside the void. The higher the void fraction of the void-containing layer is, the easier the pressure-sensitive adhesive, the adhesive and the like permeate the void. Also, the void-containing layer may become ineffective as a low-refractive index layer, due to the void fraction of the void-containing layer being degraded, thus the refractive index of the void-containing layer increasing.

Accordingly, it is an object of the present invention to provide, an optical laminate including a void-containing layer in which a pressure-sensitive adhesive, an adhesive, and the like barely permeate a void, a method for producing the optical laminate, an optical member including the optical laminate, an optical apparatus including the optical laminate, a method for producing the optical member, and a method for producing the optical apparatus.

Solution to Problem

In order to achieve the above object, the present invention provides an optical laminate including: a void-containing layer; and a low moisture permeable layer formed on the void-containing layer, wherein the low moisture permeable layer includes at least one element selected from the group consisting of metal, metal oxide, silicon, silicon oxide and an organic-inorganic hybrid material, and a moisture vapor transmission rate of the low moisture permeable layer measured by a dish method defined in JIS Z 0208-1976 is 35 $g/m^2 \cdot day$ or less.

The present invention also provides a method for producing the optical laminate of the present invention including

forming the low moisture permeable layer on a surface of at least one side of the void-containing layer, wherein the low moisture permeable layer is formed by at least one method selected from the group consisting of vacuum vapor deposition, sputtering, and chemical vapor deposition (CVD).

The present invention also provides the optical member of the present invention including the optical laminate of the present invention.

The present invention also provides the optical apparatus of the present invention including the optical member of the present invention.

The present invention also provides the method for producing the optical member of the present invention including producing the optical laminate of the present invention by the method for producing the optical laminate of the present invention.

The present invention also provides the method for producing the optical apparatus of the present invention including producing the optical member of the present invention by the method for producing the optical member of the present invention.

Advantageous Effects of Invention

The present invention can provide an optical laminate including a void-containing layer in which a pressure-sensitive adhesive, an adhesive, and the like barely permeate a void, a method for producing the optical laminate, an optical member including the optical laminate, an optical apparatus including the optical laminate, a method for producing the optical member, and a method for producing the optical apparatus.

BRIEF DESCRIPTION OF DRAWINGS

[FIG. 1] (a) of FIG. 1 is a cross-sectional view showing an example structure of the optical laminate of the present invention. (b) of FIG. 1 is a cross-sectional view showing another example structure of the optical laminate of the present invention. (c) of FIG. 1 is a cross-sectional view showing an example structure of an optical laminate which does not include a low moisture permeable layer.

[FIG. 2] (a) to (d) of FIG. 2 are cross-sectional process views showing an example process of a method for producing the optical laminate of the present invention.

DESCRIPTION OF EMBODIMENTS

The present invention will be described more specifically below with reference to illustrative examples. It is to be noted, however, that the present invention is by no means limited by the following descriptions.

In the optical laminate of the present invention, for example, the void-containing layer may have a void fraction of 30 vol% or more.

In the optical laminate of the present invention, for example, the low moisture permeable layer may include at least one element selected from the group consisting of silicon, aluminum, silicon dioxide, aluminum oxide, zinc tin complex oxide (ZTO), indium tin complex oxide (ITO), indium zinc complex oxide (IZO), gallium zinc complex oxide (GZO) and polysiloxane.

In the optical laminate of the present invention, for example, the low moisture permeable layer may have a thickness of 5 nm or more.

In the optical laminate of the present invention, for example, the low moisture permeable layer may be formed by at least one method selected from the group consisting of the vacuum vapor deposition, the sputtering, and the chemical vapor deposition (CVD).

In the optical laminate of the present invention, for example, the void-containing layer may be a porous material in which microporous particles of a silicon compound are chemically bonded with each other.

The optical laminate of the present invention, for example, may further include a pressure-sensitive adhesive/adhesive layer, wherein the pressure-sensitive adhesive/adhesive layer may be provided on the low moisture permeable layer on a side opposite to the void-containing layer.

The optical laminate of the present invention may have, for example, a haze value of less than 10 %.

Note that, in the present invention, "on" or "on a surface" may indicate directly contacting or being in contact with the surface with another layer or the like interposed therebetween.

In the present invention, a "pressure-sensitive adhesive/adhesive layer" is a layer formed of at least either of a pressure-sensitive adhesive or an adhesive. Further, in the present invention, the pressure-sensitive adhesive and the adhesive is collectively referred to as the "pressure-sensitive adhesive/adhesive" in some cases. Generally, an agent

having a relatively weak pressure-sensitive adhesive force or an adhesive force (e.g., an agent that adheres a substance in a peelable manner) is called the "pressure-sensitive adhesive", and an agent having a relatively strong pressure-sensitive adhesive force or an adhesive force (e.g., an agent that adheres a substance in a non-peelable or hardly peelable manner) is called the "adhesive" , and the two of them are distinguished in some cases. In the present invention, there is no clear distinction between the "pressure-sensitive adhesive" and the "adhesive". Also, in the present invention, there is no clear distinction between the "pressure-sensitive adhesive force" and the "adhesive force".

In the present invention, there is no clear distinction between a "film" and a "sheet". Regarding the "film" and the "sheet", generally, the one having relatively large thickness is called a "sheet" and the one having relatively small thickness is called a "film", and the two of them are distinguished in some cases, however, in the present invention, there is no clear distinction between the "film" and the "sheet".

[1. Optical laminate, optical member, and optical apparatus]

The optical laminate of the present invention includes, as described above, the void-containing layer, and the low moisture permeable layer formed on the void-containing layer, wherein the low moisture permeable layer includes at least one element selected from the group consisting of metal, metal oxide, silicon, silicon oxide and an organic-inorganic hybrid material, and the moisture vapor transmission rate of the low moisture permeable layer measured by a dish method defined in JIS Z 0208-1976 is 35 $g/m^2 \cdot day$ or less.

The cross-sectional view of (a) of FIG. 1 shows an example structure of the optical laminate of the present invention. As shown in (a) of FIG. 1, in this optical laminate 10a, a void-containing layer 12 is formed on a base 11, and a low moisture permeable layer 13 is further formed on the void-containing layer 12. The void-containing 12 layer has a void fraction of 30 vol% or more. The low permeable layer 13 includes at least one element selected from the group consisting of metal, metal oxide, silicon, silicon oxide and an organic-inorganic hybrid material.

The cross-sectional view of (b) of FIG. 1 shows another example structure of the optical laminate of the present invention. As shown in (b) of FIG. 1, this optical laminate 10b is the same as the optical laminate 10a of (a) of FIG. 1, except that a pressure-sensitive adhesive/adhesive layer 14 is further provided on the low moisture permeable layer 13 on a side opposite to the void-containing layer 12.

(c) of FIG. 1 shows an example structure of the optical laminate which does not include a low moisture permeable layer. As shown in (c) of FIG. 1, this optical laminate 20 is the same as the optical laminate 10b of (b) of FIG. 1, except that the optical laminate 20 does not include the low moisture permeable layer 13, and the pressure-sensitive adhesive/adhesive layer 14 is provided as directly in contact with the void-containing layer 12.

For example, in the optical laminate, when the pressure-sensitive adhesive/adhesive layer is formed as directly in contact with the void-containing layer as shown in (c) of FIG. 1, the pressure-sensitive adhesive/adhesive or the like which forms the pressure-sensitive adhesive/adhesive layer, permeates the void of the void-containing layer. Accordingly, the refractive index of the void-containing layer may increase due to the void fraction of the void-containing layer being degraded. For this, the inventors of the present invention have found that the optical laminate including the void-containing layer in which the pressure-sensitive adhesive, the adhesive, and the like barely permeate the void, can be provided by forming the low moisture permeable layer on the void-containing layer. Thus, the inventors have reached the present invention.

The optical laminate of the present invention includes, as described above, the void-containing layer and the low moisture permeable layer formed on the void-containing layer. The optical laminate of the present invention may include or not include a layer other than the void-containing layer and the low moisture permeable layer. For example, the optical laminate may include or not include the base 11 as the other layer, as shown in (a) and (b) of FIG. 1. Also, for example, the optical laminate may include or not include the pressure-sensitive adhesive/adhesive layer 14 as the other layer, as shown in (b) of FIG. 1. Furthermore, the optical laminate may include or not include the other layer between each of the base 11, the void-containing layer 12, the low moisture permeable layer 13 and the pressure-sensitive adhesive/adhesive layer 14.

In (a) and (b) of FIG. 1, the base 11 is not particularly limited and may be a base such as a film or the like, for example. The base is, for example, a base made of a thermoplastic resin, a base made of glass, an inorganic base plate typified by silicon, a plastic formed of a thermosetting resin, an element such as a semiconductor, or a carbon fiber-based material typified by carbon nanotube can be preferably used. The base, however, is by no means limited thereto. Examples of the form of the base include a film and a plate. Examples of the thermoplastic resin includes polyethylene terephthalate (PET), acrylic resins, cellulose acetate propionate (CAP), cycloolefin polymer (COP), triacetylcellulose (TAC), polyethylene naphthalate (PEN), polyethylene (PE), and polypropylene (PP). The thickness of the base 11 is not particularly limited and may be 10 $\mu m$ or more, 20 $\mu m$ or more, or 30 $\mu m$ or more, and may be, for example, 1000 $\mu m$ or less, 500 $\mu m$ or less, 400 $\mu m$ or less, 300 $\mu m$ or less, 200 $\mu m$ or less, or 100 $\mu m$ or less, and may be, for example, 10 $\mu m$ to 1000 $\mu m$, 10 $\mu m$ to 500 $\mu m$, or 10 $\mu m$ to 100 $\mu m$. From the viewpoint of thinning the optical laminate, it is preferable that the thickness of the base 11 be not too large. On the other hand, from the viewpoint of the strength of

the optical laminate, it is preferable that the thickness of the base 11 be not too small.

In (a) and (b) of FIG. 1, as mentioned above, the void-containing layer 12 has a void fraction of 30 vol% or more. The void-containing layer of the optical laminate of the present invention (hereinafter sometimes referred to as the "void-containing layer of the present invention") will be described below with reference to illustrative examples. However, the void-containing layer of the present invention is by no means limited by the following descriptions.

The void-containing layer of the present invention may have, for example, a void fraction of 30 vol% or more, or 35 vol% or more. Also, the void-containing layer of the present invention may have, for example, a peak pore diameter of 50 nm or less. However, this merely is an example, and the void-containing layer of the present invention is not limited thereto.

The void fraction may be, for example, 30 vol% or more, 35 vol% or more, 38 vol% or more, or 40 vol% or more, and may be 90 vol% or less, 80 vol% or less, or 75 vol% or less. The void-containing layer of the present invention may be, for example, a highly void-containing layer having a void fraction of 60 vol% or more.

The void fraction can be measured, for example, by the following measurement method.

(Measurement method of void fraction)

If the layer whose void fraction is to be measured is a single layer containing voids, the ratio (volume ratio) between the element of the layer and the air can be calculated by a standard method (e.g., weight and volume are measured to calculate the density), whereby the void fraction (vol%) can be calculated. Further, since the refractive index and the void fraction have a correlation, the void fraction can be calculated from the value of the refractive index as a layer, for example. Specifically, for example, the void fraction is calculated according to the Lorentz-Lorenz's formula from the value of the refractive index measured by an ellipsometer.

The void-containing layer of the present invention can be produced, for example, by chemical bonding of gel pulverized products (microporous particles) as will be described below. In this case, the voids of the void-containing layer can be divided into three types (1) to (3) below for convenience.

(1) Voids contained in raw material gel itself (inside the particles)
(2) Voids contained in gel pulverized product unit
(3) Voids between gel pulverized products created by deposition of gel pulverized products

The voids (2) are voids formed during pulverization, which are different from the voids (1) that can be formed in each block when each particle group generated by pulverizing the gel is regarded as one mass (block) regardless of the size or the like of the gel pulverized product (microporous particle). The voids (3) are voids created because of irregularity in the sizes or the like of the gel pulverized products (microporous particles) in pulverization (e.g., media-less pulverization). The void-containing layer of the present invention contains the voids (1) to (3), whereby an appropriate void fraction and peak pore diameter can be achieved, for example.

The peak pore diameter may be, for example, 5 nm or more, 10 nm or more, or 20 nm or more, and 50 nm or less, 40 nm or less, or 30 nm or less. In the void-containing layer, if the peak pore diameter is too large in a state where the void fraction is high, light is scattered, which makes the void-containing layer opaque. Further, in the present invention, the lower limit value of the peak pore diameter of the void-containing layer is not particularly limited, but it is preferable that the peak pore diameter is not too small because it is difficult to increase the void fraction if the peak pore diameter be too small. In the present invention, the peak pore diameter can be measured, for example, by the following method.

(Measurement method of peak pore diameter)

The peak pore diameter is calculated from the results of the BJH plot and the BET plot by nitrogen adsorption and the isothermal adsorption line using a pore distribution/specific surface area analyzer (trade name: BELLSORP MINI, MicrotracBEL Corp.).

The thickness of the void-containing layer of the present invention is not particularly limited, and may be, for example, 100 nm or more, 200 nm or more, or 300 nm or more, and 10000 nm or less, 5000 nm or less, or 2000 nm or less.

The void-containing layer of the present invention uses pulverized products of the porous gel material, for example. Thus, the three-dimensional structure of the porous gel material is destroyed, whereby a new three-dimensional structure different from that of the porous gel material is formed. As will be described below, the void-containing layer of the present invention becomes a layer having a new pore structure (new void-containing structure) that cannot be obtained in a layer formed using the porous gel material. That is, a nano-scale void-containing layer having a high void fraction can be formed. Moreover, for example, when the void-containing layer of the present invention is a silicone porous material, the pulverized products in the void-containing layer are chemically bonded to each other while adjusting the number of functional groups having siloxane bonds of the silicon compound gel, for example. Herein, a "silicone

porous material" is a high polymer porous material containing siloxane bonds and includes, for example, a porous material containing silsesquioxane as a structure unit. Furthermore, a new three-dimensional structure is formed as a void-containing layer precursor, and pulverized products are thereafter bonded chemically (e.g., crosslinked) to each other in the bonding process. Thus, when the void-containing layer of the present invention is a functional porous material, the void-containing layer has a structure with void spaces, for example. However, it can maintain a sufficient strength and sufficient flexibility. Therefore, according to the present invention, the void-containing layer can be easily and simply applied to various objects.

For example, the void-containing layer of the present invention includes pulverized products of a porous gel material as will be described below, and the pulverized products are chemically bonded to each other. In the void-containing layer of the present invention, the form of the chemical bonding (chemical bonds) between the pulverized products is not limited to particular forms. Specifically, the chemical bonds may be crosslinking bonds, for example. The method for chemically bonding the pulverized products to each other is as described in detail in, for example, the method for producing the void-containing layer described above.

The crosslinking bonds are siloxane bonds, for example. Examples of the siloxane bonds include T2, T3, and T4 bonds shown below. When the silicone porous material of the present invention includes siloxane bonds, the silicone porous material may include any one of the T2, T3, and T4 bonds, any two of them, or all three of them, for example. As the proportions of T2 and T3 among the siloxane bonds become higher, the silicone porous material becomes more flexible, so that it is expected that the silicone porous material exhibits characteristics intrinsic to the gel. However, the film strength of the silicone porous material is deteriorated. When the proportion of T4 in the siloxane bonds becomes higher, a film strength is more likely to be obtained, whereas void spaces become smaller, resulting in deteriorated flexibility. Thus, it is preferable to adjust the proportions of T2, T3, and T4 depending on the intended use of the silicone porous material, for example.

T2

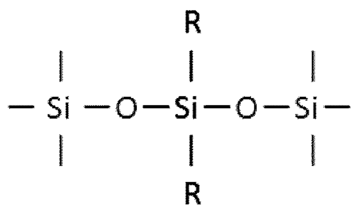

T3

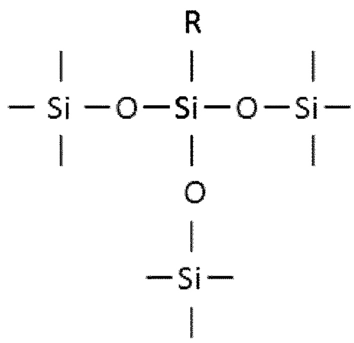

T4

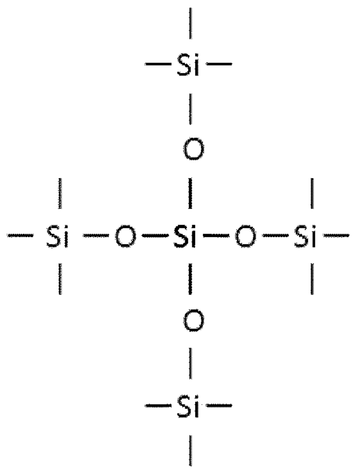

In the case where the void-containing layer of the present invention includes the siloxane bonds, the ratio of T2, T3, and T4 expressed relatively assuming that the proportion of T2 is "1" is as follows, for example: T2 : T3 : T4 = 1 :[1 to 100] :[0 to 50], 1 :[1 to 80] :[1 to 40], or 1 :[5 to 60] :[1 to 30].

It is preferable that silicon atoms contained in the void-containing layer of the present invention be bonded to each other through siloxane bonds, for example. As a specific example, the proportion of unbonded silicon atoms (i.e., residual silanol) among all the silicon atoms contained in the silicone porous material is less than 50%, 30% or less, or 15% or less, for example.

The void-containing layer of the present invention has a pore structure. In the present invention, the size of each void space in the pore structure indicates, out of the diameter of the long axis and the diameter of the short axis of the void space (pore), the diameter of the long axis. The size of the void space (pore) is from 5 nm to 50 nm, for example. The lower limit of the size is, for example, 5 nm or more, 10 nm or more, or 20 nm or more. The upper limit of the size is, for example, 50 nm or less, 40 nm or less, or 30 nm or less. The range of the size is, for example, from 5 nm to 50 nm or from 10 nm to 40 nm. A preferable size of the void spaces is determined depending on the use of the void-containing structure. Thus, it is necessary to adjust the size of the void spaces to a desired value according to the intended use, for example. The size of the void spaces can be evaluated in the following manner, for example.

(SEM observation of cross section of void-containing layer)

In the present invention, the void-containing layer can be observed and analyzed using a scanning electron microscopy (SEM). Specifically, for example, the void-containing layer is subjected to FIB processing (acceleration voltage: 30 kV) while being cooled, and the cross-sectional electronic image of the obtained cross-sectional sample can be obtained by FIB-SEM (trade name: Helios NanoLab 600, manufactured by FEI Company, acceleration voltage: 1 kV) at an observing magnification of 100,000×.

(Evaluation of size of void spaces)

In the present invention, the size of the void spaces can be quantified according to the BET test. Specifically, 0.1 g of a sample (the void-containing layer of the present invention) is set in a capillary tube of a pore distribution/surface area measurement apparatus (trade name: BELLSORP MIN, manufactured by MicrotracBEL Corp.), and dried under reduced pressure at room temperature for 24 hours to remove gas in the void-containing structure. Then, a BET plot, a BJH plot, and an adsorption isotherm are created by causing the sample to adsorb nitrogen gas, whereby the pore distribution is determined. On the basis of the thus-determined pore distribution, the size of the void spaces can be evaluated.

The void-containing layer of the present invention may have, for example, a pore structure (porous structure) as mentioned above, and the pore structure may be an open-cell structure in which pores are interconnected with each other, for example. The open-cell structure means that, for example, in the void-containing layer, pores three-dimensionally communicate with each other. In other words, the open-cell structure means the state where void spaces inside the pore structure are interconnected with each other. When a porous material has an open-cell structure, this structure allows the bulk body to have a higher void fraction. However, in the case where closed-cell particles such as hollow silica particles are used, an open-cell structure cannot be formed. In contrast, in the void-containing layer of the present invention, an open-cell structure can be formed easily for the following reason. Sol particles (pulverized products of a porous gel material for forming a sol) each have a dendritic structure, so that the open-cell structure is formed as a result of sedimentation and deposition of the dendritic particles in a coating film (a coating film formed of a sol containing pulverized products of the porous gel material). Further, it is more preferable that the void-containing layer of the present invention form a monolith structure, which is an open-cell structure including two or more types of micropore distributions. The monolith structure refers to a layered structure including a structure in which nano-sized void spaces are present and an open-cell structure formed by aggregation of the nano-sized spaces, for example. When the monolith structure is formed, for example, the film strength is imparted by the minute void spaces whereas a high void fraction is achieved by the presence of the void spaces forming a bulky open-cell structure. Thus, both a film strength and a high void fraction can be attained. In order to form such a monolith structure, for example, first, in the porous gel material before being pulverized into the pulverized products, it is important to control the micropore distributions in a void-containing structure to be generated. Also, the monolith structure can be formed by, for example, controlling, at the time of pulverizing the porous gel material, the particle sizes of the pulverized products so that a desired particle size distribution can be obtained.

In the void-containing layer of the present invention, the haze value indicating the transparency is not particularly limited. The lower limit of the haze is, for example, 0.1% or more, 0.2% or more, or 0.3% or more. The upper limit of the haze is, for example, 10% or less, 5% or less, or 3% or less. The range of the haze value is, for example, from 0.1% to 10%, from 0.2% to 5%, or from 0.3% to 3%.

The haze value can be measured in the following manner, for example.

(Evaluation of haze value)

A void-containing layer (the void-containing layer of the present invention) is cut into a piece with a size of 50 mm × 50 mm, and the thus-obtained cut piece is set in a haze meter (HM-150, manufactured by Murakami Color Research Laboratory) to measure the haze value. The haze value is calculated by the following formula.

$$\text{Haze value (\%)} = [\text{diffuse transmittance (\%)}/\text{total light transmittance (\%)}] \times 100\ (\%)$$

The "refractive index" of a given medium generally refers to the ratio of transmission speed of the wavefront of light in vacuum to the phase velocity of the light in the medium. The refractive index of the void-containing layer of the present invention is not particularly limited, and the upper limit thereof is, for example, 1.3 or less, less than 1.3, 1.25 or less, 1.2 or less, or 1.15 or less, the lower limit thereof is, for example, 1.05 or more, 1.06 or more, or 1.07 or more, and the range thereof is, for example, 1.05 or more and 1.3 or less, 1.05 or more and less than 1.3, 1.05 or more and 1.25 or less, 1.06 or more and less than 1.2, or 1.07 or more and 1.15 or less.

In the present invention, the refractive index refers to the one measured at a wavelength of 550 nm, unless otherwise stated. The method for measuring the refractive index is not particularly limited. For example, the refractive index can be measured in the following manner.

(Evaluation of refractive index)

A void-containing layer (the void-containing layer of the present invention) is formed on an acrylic film, and the obtained laminate is then cut into a piece with a size of 50 mm × 50 mm. The thus-obtained cut piece is adhered onto a surface of a glass plate (thickness: 3 mm) with a pressure-sensitive adhesive layer. The central portion (diameter: about 20 mm) of the back surface of the glass plate is painted entirely with black ink, thereby preparing a sample that allows no reflection at the back surface of the glass plate. The sample is set in an ellipsometer (VASE, manufactured by J. A. Woollam Japan), and the refractive index is measured at a wavelength of 550 nm and at an incidence angle of 50° to 80°. The mean value of the thus-obtained measured values is set as the refractive index.
The thickness of the void-containing layer of the present invention is not particularly limited, and the lower limit thereof is, for example, 0.05 μm or more or 0.1 μm or more, and the upper limit thereof is, for example, 1000 μm or less or 100 μm or less, and the range thereof is, for example, from 0.05 to 1000 μm or 0.1 to 100 μm.
The form of the void-containing layer of the present invention is not particularly limited, and may be, for example, in the form of a film, a block, or the like.
In (a) and (b) of FIG. 1, the low moisture permeable layer 13 includes at least one element selected from the group consisting of metal, metal oxide, silicon, silicon oxide and an organic-inorganic hybrid material. The low moisture permeable layer used in the optical laminate of the present invention (hereinafter sometimes referred to as the "low moisture permeable layer of the present invention") will be described below with reference to illustrative examples.
In the low moisture permeable layer of the present invention, the metal is not particularly limited and may be, for example, aluminum, zinc, tin, indium, gallium, lead, and the like. The metal oxide is not particularly limited and may be, for example, as mentioned above, aluminum oxide (e.g., $Al_2O_3$), zinc tin complex oxide (ZTO), indium tin complex oxide (ITO), indium zinc complex oxide (IZO), gallium zinc complex oxide (GZO), and the like. In the present invention, the silicon oxide is, for example, a compound expressed by SiOx ($0<x\leq2$). The silicon oxide is not particularly limited and may be, for example, silicon dioxide ($SiO_2$) or the like. The organic-inorganic hybrid material is not particularly limited and may be, for example, polysiloxane resin, silsesquioxane resin, and the like. Herein, in the present invention, the "organic-inorganic hybrid material" is a material in which both of an organic element and an inorganic element exist in the same molecule.
The low moisture permeable layer of the present invention may include or not include an element other than at least one element selected from the group consisting of metal, metal oxide, silicon, silicon oxide and an organic-inorganic hybrid material. In the case where the low moisture permeable layer of the present invention includes the other element, the content of the other element is not limited to particular contents and may be, for example, 10 mass% or less, 5 mass% or less, or 1 mass% or less. The lower limit value of the content of the other element is not limited to particular contents and is, for example, over 0 mass%.
The method for forming the low moisture permeable layer of the present invention is not particularly limited and is preferably a so-called dry process (a method for forming without using a solvent). Specifically, for example, as mentioned above, the low moisture permeable layer may be formed by at least one method selected from the group consisting of the vacuum vapor deposition, the sputtering, and the chemical vapor deposition (CVD). The specific methods for performing the vacuum vapor deposition, the sputtering, and the chemical vapor deposition (CVD) are not particularly limited and may be, for example, the same as or based on commonly used methods.
In the low moisture permeable layer of the present invention, a moisture vapor transmission rate measured by a dish method defined in JIS Z 0208-1976 is 35 $g/m^2\cdot day$ or less, as mentioned above. The moisture vapor transmission rate of the low moisture permeable layer of the present invention is measured using a sample laminate, obtained by laminating a low moisture permeable layer on a 30 μm acrylic base (trade name: RZ-30NC-1330, manufactured by Toyo Kohan Co., Ltd.) under the same condition as the low moisture permeable layer of the present invention. The thus-obtained sample laminate is set so that the low moisture permeable layer faces inside the dish and the acrylic base faces outside the dish to measure the moisture vapor transmission rate. Note that, in the present invention, "day" in "$g/m^2\cdot day$" which is the unit of the moisture vapor transmission rate, is synonymous with 24 h (24 hours). The moisture vapor transmission rate may be, for example, 30 $g/m^2\cdot day$ or less, 28 $g/m^2\cdot day$ or less, or 26 $g/m^2\cdot day$ or less. The lower limit value of the moisture vapor transmission rate is not particularly limited and may be, for example, 0 $g/m^2\cdot day$ or over 0 $g/m^2\cdot day$, and for example, 10^-1 $g/m^2\cdot day$ or more, or 10^-2 $g/m^2\cdot day$ or more. From this, although a mechanism of the low moisture permeable layer with a low moisture vapor transmission rate restraining the pressure-sensitive adhesive, the adhesive and the like from permeating the void of the void-containing layer is not obvious, for example, it is considered that the low moisture permeable layer cuts off a molecule smaller than a hole diameter of the void of the void-containing layer (a molecule of the pressure-sensitive adhesive, the adhesive, and the like, for example), so that the small molecule

cannot transfer into the void-containing layer. Generally, under conditions of heating, humidifying, and the like, a molecule of the pressure-sensitive adhesive, the adhesive and the like easily moves, so that the molecule of the pressure-sensitive adhesive, the adhesive, and the like particularly easily permeate inside the void of the void-containing layer. However, the low moisture permeable layer of the present invention can restrain the pressure-sensitive adhesive, the adhesive, and the like from permeating the void of the void-containing layer, even under such a condition in which the molecule of the pressure-sensitive adhesive, the adhesive and the like easily permeate inside the void of the void-containing layer.

A method for forming the low moisture permeable layer of the present invention having a low moisture vapor transmission rate as mentioned above, is not particularly limited. The low moisture permeable layer of the present invention having a low moisture vapor transmission rate as mentioned above, can be formed by forming the low moisture permeable layer with a certain or more thickness, by at least one method selected from the group consisting of vacuum vapor deposition, sputtering, and chemical vapor deposition (CVD), using at least one element selected from the group consisting of metal, metal oxide, silicon, silicon oxide and an organic-inorganic hybrid material, for example.

Thickness of the low moisture permeable layer is not particularly limited and may be, for example, 3 nm or more, 4 nm or more, 5 nm or more, 8 nm or more, 10 nm or more, 20 nm or more, 40 nm or more, 60 nm or more, 80 nm or more, or 100 nm or more, and for example, 200 nm or less, 150 nm or less, 100 nm or less, or 50 nm or less, and for example, 3 to 200 nm, 10 to 200 nm, or 20 to 200 nm. From the viewpoint of thinning the optical laminate, it is preferable that the thickness of the low moisture permeable layer of the present invention be not too large. On the other hand, from the viewpoint of restraining the pressure-sensitive adhesive/adhesive from permeating the void, it is preferable that the thickness of the low moisture permeable layer of the present invention be not too small.

In (b) of FIG. 1, the pressure-sensitive adhesive/adhesive layer 14 is not particularly limited and may be, for example, a pressure-sensitive adhesive layer formed of a pressure-sensitive adhesive (pressure sensitive adhesive composition). In the optical laminate of the present invention, the thickness of the pressure-sensitive adhesive/adhesive layer is not particularly limited and may be 3 μm or more, 5 μm or more, or 10 μm or more, and for example, 100 μm or less, 75 μm or less, or 50 μm or less, and for example, 3 to 100 μm, 3 to 50 μm, or 5 to 25 μm. The pressure-sensitive adhesive is not particularly limited and may be, for example, an (meth) acrylic polymer and the like. The (meth)acrylic polymer and the like may be, for example, used as the pressure-sensitive adhesive (the pressure-sensitive adhesive composition) in a configuration of a solution or a dispersion, by being dissolved or dispersed in a solvent. An example of the solvent includes ethyl acetate, and one type of the solvent may be used alone or two or more of the solvents may be used in combination. A concentration of a solute or a dispersoid (e.g., the acrylic polymer) in the solution or the dispersion may be, for example, 10 mass% or more, or 15 mass% or more, and for example, 60 mass% or less, 50 mass% or less, 40 mass% or less, or 25 mass% or less. Note that, in the present invention, a "(meth)acrylic polymer" is a polymer or a copolymer of at least one kind of a monomer of (meth)acrylic acid, (meth)acrylic ester or (meth)acrylamide. Further, in the present invention, "(meth)acrylic acid" indicates "at least one of acrylic acid and methacrylic acid", and "(meth)acrylic ester" indicates "at least one of acrylic ester and methacrylic ester". Examples of the (meth)acrylic ester include linear or branching alkyl ester of (meth)acrylic acid. In the linear or branching alkyl ester of (meth)acrylic acid, a carbon number of an alkyl group may be, for example, 1 or more, 2 or more, 3 or more, or 4 or more, and for example, 18 or less, 16 or less, 14 or less, 12 or less, 10 or less, or 8 or less. The alkyl group may be, for example, replaced or not replaced by one or two or more substituents. An example of the substituent includes a hydroxyl group, and the substituent may be the same or different when there are two or more substituents. Specific examples of the (meth)acrylic ester include, 2-ethylhexyl acrylate, 2-hydroxyethyl acrylate, and 4-hydroxybutyl acrylate. Also, one type of the pressure-sensitive adhesive may be used alone or two or more of the pressure-sensitive adhesives may be used in combination.

The optical laminate of the present invention, as mentioned above, may include or not include the pressure-sensitive adhesive/adhesive layer.

In the optical laminate of the present invention, for example, a light transmittance of the entire optical laminate may be 80 % or more. Also, for example, a haze of the entire optical laminate may be less than 10 %, or 3 % or less, as mentioned above. The lower limit value of the haze of the entire optical laminate is not particularly limited, and is 0 or more, or over 0. Note that, the "entire optical laminate" indicates, for example, the entire optical laminate 10a including the base 11, the void-containing layer 12 and the low moisture permeable layer 13 in (a) of FIG. 1, and the optical laminate 10b including the base 11, the void-containing layer 12, the low moisture permeable layer 13 and the pressure-sensitive adhesive/adhesive layer 14 in (b) of FIG. 1. The light transmittance may be, for example, 82% or more, 84% or more, 86% or more, or 88% or more, and the upper limit is not particularly limited, and is ideally 100 %, and may be, for example, 95% or less, 92% or less, 91% or less, or 90% or less. The haze of the optical laminate can be measured by, for example, the same measurement method as that of the haze of the void-containing layer described above. Further, the light transmittance is the transmittance of the light having a wavelength of 550 nm, and can be measured, for example, by the following measurement method.

(Measurement method of light transmittance)

A spectrophotometer U-4100 (trade name, manufactured by Hitachi, Ltd.) is used, and the laminate is used as a sample to be measured. The total light transmittance (light transmittance) of the sample is measured with the total light transmittance of air being considered to be 100%. The value of the total light transmittance (light transmittance) is a value measured at a wavelength of 550 nm.

In the optical laminate of the present invention, a pressure-sensitive adhesive force or an adhesive force of the pressure-sensitive adhesive/adhesive layer is not particularly limited and may be, for example, 0.7 N/25 mm or more, 0.8 N/25 mm or more, 1.0 N/25 mm or more, or 1.5 N/25 mm or more, and may be 50 N/25 mm or less, 30 N/25 mm or less, 10 N/25 mm or less, 5 N/25 mm or less, or 3 N/25 mm or less. From the viewpoint of risks of peeling off at the time of handling when the laminate is adhered to other layers, it is preferable that the pressure-sensitive adhesive force or the adhesive force of the pressure-sensitive adhesive/adhesive layer be not too low. In addition, from the viewpoint of rework at the time of reattachment, it is preferable that the pressure-sensitive adhesive force or the adhesive force of the pressure-sensitive adhesive/adhesive layer be not too high. The pressure-sensitive adhesive force or the adhesive force of the pressure-sensitive adhesive/adhesive layer can be measured, for example, as follows.

(Measurement method of pressure-sensitive adhesive force or adhesive force)

From the laminated film of the present invention (the film in which the optical laminate of the present invention is formed on a resin film base), a strip-shaped piece with a size of 50 mm × 140 mm is obtained as a sample, and the sample is fixed to a stainless plate with a double-sided tape. An acrylic pressure-sensitive adhesive layer (thickness: 20 μm) is adhered to a PET film (T100: manufactured by Mitsubishi Plastics, Inc.), and the thus-obtained adhesive tape is cut into a piece with a size of 25 mm × 100 mm. The thus-obtained cut piece is adhered to the laminated film of the present invention on the side opposite to the resin film to form a laminate of the PET film and the laminated film. Then, the sample is chucked in an autograft tensile testing machine (AG-Xplus, manufactured by Shimadzu Corporation) with a distance between chucks being 100 mm, and the tensile test is performed at a tensile speed of 0.3 m/min. The mean value of the peel test data for 50 mm is set as the peel adhesion strength, i.e., pressure-sensitive adhesive force. The adhesive force can also be measured by the same measurement method. In the present invention, there is no clear distinction between the "pressure-sensitive adhesive force" and the "adhesive force".

The intended use of the optical laminate of the present invention is not particularly limited and may be, for example, for use in the optical member and the optical apparatus of the present invention.

The optical member of the present invention is not particularly limited, and may be, for example, an optical film including the optical laminate of the present invention.

The optical apparatus (optical device) of the present invention is not particularly limited, and may be, for example, an image display device, an illumination device, and the like. Examples of the image display device include a liquid crystal display, an organic EL (electro luminescence) display, and a micro-LED (light emitting diode) display. The illumination device may be, for example, an organic EL illumination, or the like.

The intended use and the usage of the optical member and the optical apparatus of the present invention are not particularly limited and may be, for example, the same as a general optical member or a general optical apparatus (e.g., the image display device or the illumination device).

[2. Method for producing optical laminate, method for producing optical member, and method for producing optical apparatus]

A method for producing the optical laminate of the present invention is not particularly limited and can be produced, for example, as follows.

Cross-sectional process views (a) to (d) of FIG. 2 show an example process in the method for producing the optical laminate of the present invention. Firstly, as shown in (a) of FIG. 2, the base 11 is prepared. The base 11 is not particularly limited and is, for example, as mentioned above.

Next, as shown in (b) of FIG. 1, the void-containing layer 12 is formed on a surface of one side of the base 11 (void-containing layer forming process). The forming method (production method) of the void-containing layer 12 is not particularly limited and can be, for example, the method described in WO 2019/065999 or WO 2019/065803, which are incorporated herein by reference. More specifically, the method for forming the void-containing layer 12 can be, for example, the method wherein the coating solution for forming the void-containing layer is coated on the surface of one side of the base 11, then dried, and if needed, further cured, or reacted with a crosslinking, by light irradiation, chemical treatment (e.g., crosslinking treatment) and the like. The coating solution may be, for example, a sol particle solution of pulverized products of a gelled compound. The gelled compound may be, for example, silicon oxide (e.g., silica gel or the like). A method for producing the sol particle solution of pulverized products of a gelled compound is not particularly

limited and can be, for example, the methods described in WO 2019/065999 or WO 2019/065803. Also, the sol particle solution can be produced by the method described in the following "Reference Example 1" of the present example. A method for coating the coating solution is not particularly limited, and a commonly used coating method can be employed. Examples of the coating method include a slot die method, a reverse gravure coating method, a micro-gravure method (micro-gravure coating method), a dip method (dip coating method), a spin coating method, a brush coating method, a roller coating method, a flexography, a wire-bar coating method, a spray coating method, an extrusion coating method, a curtain coating method, and a reverse coating method. Among them, from the viewpoint of productivity, smoothness of a coating film, etc., the extrusion coating method, the curtain coating method, the roller coating method, and the micro-gravure coating method are preferable.

Next, as shown in (c) of FIG. 2, the low moisture permeable layer 13 is formed on the void-containing layer 12 on a side opposite to the base 11 (low moisture permeable layer forming process). In forming the low moisture permeable layer, the low moisture permeable layer 13 is formed by at least one method selected from the group consisting of the vacuum vapor deposition, the sputtering, and the chemical vapor deposition (CVD). These methods are not particularly limited and may be, for example, as described above, the same as or based on commonly used vacuum vapor deposition, sputtering, and chemical vapor deposition (CVD). A material, thickness, and the like of the low moisture permeable layer 13 are, for example, as described above. In this way, as shown in (c) of FIG. 2, the optical laminate 10a including the void-containing layer 12 formed on the base 11 and the low moisture permeable layer 13 further formed on the void-containing layer 12, can be produced. Note that, the optical laminate 10a of (c) of FIG. 2 is the same as the optical laminate 10a of (a) of FIG. 1.

Furthermore, as shown in (d) of FIG. 2, the optical laminate 10b may be produced by further forming the pressure-sensitive adhesive/adhesive layer 14 on the low moisture permeable layer 13 on a side opposite to the void-containing layer 12 in the optical laminate 10a of (c) of FIG. 2. The forming method (production method) of the pressure-sensitive adhesive/adhesive layer 14 is not particularly limited and may be, for example, the same as or based on a commonly used forming method of the pressure-sensitive adhesive/adhesive layer. More specifically, the forming method may be, for example, coating the pressure-sensitive adhesive or the adhesive on the surface of the low moisture permeable layer 13, and if needed, further heating or the like. The pressure sensitive adhesive or the adhesive is not particularly limited and is, for example, as described above.

Also, a method for producing the optical laminate 10a of (a) or 10b of (b) of FIG. 1 may be, for example, processing each of the above-described processes while continuously delivering the long-sized film base 11.

Methods for producing the optical member and the optical apparatus of the present invention are not particularly limited. For example, the method for producing the optical member of the present invention may be, for example, the same as a method for producing a general optical member, except that the optical laminate of the present invention is produced by a freely-selected production method (e.g., the production method described above). Also, the method for producing the optical apparatus of the present invention may be, for example, the same as a method for producing a general optical apparatus, except that the optical laminate of the present invention is produced by a freely-selected production method (e.g., the production method mentioned above).

## Examples

Next, examples of the present invention will be described below. It is to be noted, however, that the present invention is by no means limited to the following examples.

In the following reference examples, examples, and comparison examples, the number (relative usage amount) of each substance is the mass part (weight part) unless otherwise stated.

### [Reference Example 1]

A coating solution for forming the void-containing layer (low refractive index layer) was prepared as described below.

### (1) Gelation of silicon compound

A resultant mixture A was prepared by dissolving 0.95 g of methyl trimethoxy silane (MTMS), which is a silicon compound precursor, in 2.2 g of dimethyl sulfoxide (DMSO). Then, to generate a resultant mixture B including tris(hydroxy)methyl silane, 0.5 g of 0.01 mol/L oxalic acid aqueous solution was added to the resultant mixture A, and stirred at room temperature for 30 minutes, thereby hydrolyzing the MTMS.

0.38 g of ammonia water with an ammonia concentration of 28% and 0.2 g of pure water were added to 5.5 g of DMSO. Thereafter, the resultant mixture B was further added, and stirred at room temperature for 15 minutes to cause gelation of tris(hydroxy)methyl silane. Thus, a resultant mixture C including the gelled silicon compound was obtained.

(2) Aging treatment

The resultant mixture C including the gelled silicon compound prepared by the "(1) Gelation of silicon compound" was subjected to an aging treatment by being incubated at 40°C for 20 hours.

(3) Pulverizing treatment

The gelled silicon compound in the resultant mixture C aging treated by the "(2) Aging treatment", was pulverized in sizes of several millimeters to several centimeters to be granular, using a spatula. Then, 40 g of isopropyl alcohol (IPA) was added to the resultant mixture C and stirred lightly. Thereafter, the resultant mixture C after being stirred was allowed to stand at room temperature for 6 hours, and a decantation of a solvent and a catalyst in the gel was carried out. By replacing the solvent with 3 times of the same decantation treatment, a resultant mixture D was obtained. Then, the gelled silicon compound in the resultant mixture D was pulverizing-treated (by high pressure media-less pulverization). For the pulverizing treatment (high pressure media-less pulverization), a homogenizer (trade name: UH-50, manufactured by SMT Co., Ltd.) was used. In the pulverizing treatment (high pressure media-less pulverization), 1.85 g of the gelled compound and 1.15 g of IPA in the resultant mixture D were weighed and put into a 5 cc screw bottle, and pulverized for 2 minutes under conditions of 50 w and 20 kHz.

Through this pulverizing treatment, the gelled silicon compound in the resultant mixture D was pulverized, and the resultant mixture D became a resultant mixture D', which is a sol solution of pulverized products. The volume average particle diameter, showing a variation in particle size of the pulverized products in this resultant mixture D', was demonstrated to be 0.50 to 0.70 using a dynamic light scattering nanotrac particle size analyzer (UPA-EX 150, manufactured by Nikkiso Co.,Ltd.). Further, to 0.75 g of this sol solution (resultant mixture D'), 0.062 g of MEK (methyl ethyl ketone) solution with a photo base generator (trade name: WPBG266, manufactured by Wako Pure Chemical Corporation) concentration of 1.5 wt%, and 0.036 g of MEK solution with bis(trimethoxysilyl)ethane concentration of 5 % were added, thereby obtaining the intended coating solution for forming the void-containing layer.

[Reference Example.2]

A laminate of an acrylic pressure-sensitive adhesive layer and a PET film was produced as described below. Firstly, 90.7 parts of butyl acrylate, 6 parts of N-acryloyl morpholine, 3 parts of acrylic acid, 0.3 parts of 2-hydroxybutyl acrylate, and 0.1 parts by weight of 2,2'-azobisisobutyronitrile as a polymerization initiator were put into a four-neck flask equipped with a stirring blade, a thermometer, a nitrogen gas inlet tube, and a cooler together with 100 g of ethyl acetate. Then, nitrogen gas was introduced while gently stirring the contents of the four-neck flask to perform nitrogen replacement. Thereafter, a polymerization reaction was performed for 8 hours while maintaining the solution temperature in the four-neck flask at about 55°C, thereby preparing an acrylic polymer solution. To 100 parts of the solid content of the acrylic polymer solution obtained, 0.2 parts of an isocyanate crosslinking agent (trade name: "Coronate L" manufactured by Nippon Polyurethane Industry Co., Ltd., an adduct of trimethylolpropane with trilene diisocyanate), 0.3 parts of benzoyl peroxide (trade name: "NYPER BMT" manufactured by NOF CORPORATION), and 0.2 parts of γ-glycidoxypropylmethoxysilane (trade name: "KBM-403" manufactured by Shin-Etsu Chemical Co., Ltd.) were added, thereby preparing an acrylic pressure-sensitive adhesive solution. Then, the thus-obtained acrylic pressure-sensitive adhesive solution was coated on one side of the silicon treated polyethylene terephthalate (PET) film (manufactured by Mitsubishi Chemical Polyester Film Corporation, thickness: 38 μm) so as the pressure-sensitive adhesive layer to have a thickness of 10 μm after being dried, and the PET film was dried at 150°C for 3 minutes, thereby preparing the laminate of a pressure-sensitive adhesive layer and the PET film.

[Example. 1]

The coating solution for forming the void-containing layer produced in Reference Example 1 was coated on the acrylic film (base) having a thickness of 30 μm, and further dried by heating at 100°C for 2 minutes, thereby forming the void-containing layer. The void-containing layer formed was a super low refractive index layer having a refractive index of 1.18. Also, a void fraction of the void-containing layer was 60 vol%. Further, on the void-containing layer formed, a $SiO_2$ layer with a thickness of 20 nm was formed by sputtering, thereby obtaining the intended optical laminate of the present invention. Note that, the $SiO_2$ layer corresponds to the "low moisture permeable layer" of the optical laminate of the present invention. The sputtering was performed using a known sputtering apparatus and so as the sputtering in the following every example. Also, in the present example and each of the following examples and reference examples, a refractive index of the void-containing layer was measured by the measurement method described above.

Further, the laminate produced in Reference Example 2 was adhered onto the low moisture permeable layer, and the PET film on the pressure-sensitive adhesive layer (pressure-sensitive adhesive/adhesive layer) was peeled off,

thereby producing the optical laminate of the present invention including the pressure-sensitive adhesive/adhesive layer.

[Example.2]

The optical laminate of the present example was obtained in the same way as in Example 1 except that a Si layer with a thickness of 20 nm was formed as the low moisture permeable layer by the sputtering, as a substitute for the $SiO_2$ layer with a thickness of 20 nm.

[Example.3]

The optical laminate of the present example was obtained in the same way as in Example 1 except that a ZTO layer with a thickness of 50 nm was formed as the low moisture permeable layer by the sputtering, as a substitute for the $SiO_2$ layer with a thickness of 20 nm.

[Example.4]

The optical laminate of the present example was obtained in the same way as in Example 1 except that a polysiloxane layer with a thickness of 8 nm was formed as the low moisture permeable layer, as a substitute for the $SiO_2$ layer with a thickness of 40 nm. Also, in the present example, the polysiloxane layer was formed by the vapor deposition using a solution made by dissolving octadecyltrichlorosilane (manufactured by Tokyo Chemical Industry Co., Ltd.) in a fluorine-based solvent (trade name: Novec7100, manufactured by 3M)

[Comparative Example. 1]

The optical laminate of the present comparative example was produced in the same way as in Example 1 except that the low moisture permeable layer ($SiO_2$ layer with a thickness of 40 nm) was not formed in the optical laminate. In other words, in the optical laminate of the present comparative example, the pressure-sensitive adhesive/adhesive layer was formed as being directly in contact with a surface of the void-containing layer.

[Comparative Example.2]

The optical laminate of the present comparative example was produced in the same way as in Example 1 except that the thickness of the $SiO_2$ layer was changed from 20 nm to 10 nm.

[Comparative Example.3]

The optical laminate of the present comparative example was produced in the same way as in Example 2 except that the thickness of the Si layer was changed from 20 nm to 10 nm.

For the optical laminate in each of the examples and the comparative examples produced as described above, a moisture vapor transmission rate of the low moisture permeable layer was measured. Further, for the optical laminate of each of the examples and the comparative examples including the pressure-sensitive adhesive/adhesive layer, contrast of the refractive index $\Delta n$ before and after a heating and humidifying endurance test was measured. These test results (measurement results) are collectively shown in the following Table 1.

[Moisture vapor transmission rate test method]

<Measurement method>

The moisture vapor transmission rate of the low moisture permeable layer in the optical laminate of each of the examples and the comparative examples, was measured by the dish method defined in JIS Z 0208-1976. Specifically, a low moisture permeable layer was laminated on a 30 μm acrylic base (trade name: RZ-30NC-1330, manufactured by Toyo Kohan Co., Ltd.) under the same condition as in producing the optical laminate of each of the examples and the comparative examples, and the thus-obtained laminate was used as a measurement sample. The measurement sample was set so that the low moisture permeable layer faces inside the dish and the base (acrylic film) faces outside the dish, and the moisture vapor transmission rate was measured.

[Heating and humidifying endurance test method]

<Measurement method>

The optical laminate of each of the examples and the comparative examples including the pressure-sensitive adhesive/adhesive layer was used as a measurement sample. The measurement sample was put into a 60°C 90 % RH oven, and allowed to stand for 240 h, thereby performing the heating and humidifying endurance test. Before and after allowing the measurement sample to stand for 240 h in the oven, the single refractive index of the void-containing layer was measured, and the contrast of the refractive index Δn was calculated based on the following formula (1). The optical laminate with Δn of 0.010 or less was evaluated as good, and the optical laminate with Δn of over 0.010 was evaluated as poor. For a method for measuring the refractive index, laser light with a wavelength of 407 nm was made incident on the measurement sample via a coupling prism, using a prism coupler (model 2010) manufactured by Metricon Co., thereby measuring the refractive index in TE polarization.

$$\Delta n = n_a - n_b \quad (1)$$

$n_a$ in the formula (1) is a single refractive index of the void-containing layer before being put into the 60°C 90 % RH oven, and $n_b$ is a single refractive index of the void-containing layer after the measurement sample was allowed to stand in the 60°C 90 % RH oven for 240 h.

[Table. 1]

| Example number | Structure of optical laminate | Moisture vapor transmission rate | Δn ≤ 0.010 (60°C 90 %_240h) |
|---|---|---|---|
| Ex. 1 | $SiO_2$ layer of 20 nm is laminated on void-containing layer | 22 | Good (0.006) |
| Ex. 2 | Si layer of 20 nm is laminated on void-containing layer | 26 | Good (0.007) |
| Ex.3 | ZTO layer of 50 nm is laminated on void-containing layer | 8 | Good (0.003) |
| Ex.4 | Polysiloxane layer of 8 nm is laminated on void-containing layer | 35 | Good (0.010) |
| Comp. Ex. 1 | No laminate | 100 | Poor (0.042) |
| Comp. Ex. 2 | $SiO_2$ layer of 10 nm is laminated on void-containing layer | 40 | Poor (0.013) |
| Comp. Ex. 3 | Si layer of 10 nm is laminated on void-containing layer | 45 | Poor (0.019) |

As shown in table 1, in the optical laminates of the examples including the low moisture permeable layer, the pressure-sensitive adhesive was restrained from permeating the void of the void-containing layer, thus the contrast of the refractive index Δn before and after the heating and humidifying endurance test was small. In contrast, in the optical laminate of Comparative Example 1 without the low moisture permeable layer, the pressure-sensitive adhesive permeated the void of the void-containing layer during the heating and humidifying endurance test, thus Δn was large. Although the optical laminates of Comparative Examples 2 and 3 each included the $SiO_2$ layer and the Si layer, thickness of these $SiO_2$ layer and Si layer is small, so that the moisture vapor transmission rate was high. Therefore, in the optical laminates of Comparative Example 2 and 3, the pressure-sensitive adhesive permeated the void of the void-containing layer during the heating and humidifying endurance test, thus Δn was large.

Industrial Applicability

As described above, the present invention can provide an optical laminate including a void-containing layer in which a pressure-sensitive adhesive, an adhesive, and the like barely permeate the void, a method for producing the optical laminate, an optical member including the optical laminate, an optical apparatus including the optical laminate, a method for producing the optical member, and a method for producing the optical apparatus. The application of the

present invention is not particularly limited. For example, the optical apparatus of the present invention is not particularly limited, and may be an image display device, an illumination device, or the like. Examples of the image display device include a liquid crystal display, an organic EL display, and a micro LED display. The illumination device may be, for example, an organic EL illumination, or the like. Furthermore, the application of the optical laminate of the present invention is not limited to the optical member and the optical apparatus of the present invention, and can be used in a wide range of applications.

This application claims priority from Japanese Patent Application No. 2021-058829 filed on March 30, 2021. The entire subject matter of the Japanese Patent Application is incorporated herein by reference.

Reference Signs List

| | |
|---|---|
| 10a, 10b, 20: | optical laminate |
| 11: | base |
| 12: | void-containing layer |
| 13: | low moisture permeable layer |
| 14: | pressure-sensitive adhesive/adhesive |

## Claims

1. An optical laminate, comprising:

   a void-containing layer; and
   a low moisture permeable layer formed on the void-containing layer, wherein
   the low moisture permeable layer comprises at least one element selected from the group consisting of metal, metal oxide, silicon, silicon oxide and an organic-inorganic hybrid material, and a moisture vapor transmission rate of the low moisture permeable layer measured by a dish method defined in JIS Z 0208-1976 is 35 $g/m^2 \cdot day$ or less.

2. The optical laminate according to claim 1, comprising:
   the void-containing layer with a void fraction of 30 vol% or more.

3. The optical laminate according to claim 1 or 2, wherein
   the low moisture permeable layer comprises at least one element selected from the group consisting of silicon, aluminum, silicon dioxide, aluminum oxide, zinc tin complex oxide (ZTO), indium tin complex oxide (ITO), indium zinc complex oxide (IZO), gallium zinc complex oxide (GZO) and polysiloxane.

4. The optical laminate according to any one of claims 1 to 3, comprising:
   the low moisture permeable layer with a thickness of 5 nm or more.

5. The optical laminate according to any one of claims 1 to 4, comprising:
   the low moisture permeable layer formed by at least one method selected from the group consisting of vacuum vapor deposition, sputtering, and chemical vapor deposition (CVD).

6. The optical laminate according to any one of claims 1 to 5, wherein
   the void-containing layer is a porous material in which microporous particles of a silicon compound are chemically bonded with each other.

7. The optical laminate according to any one of claims 1 to 6 further comprising:

   a pressure-sensitive adhesive/adhesive layer, wherein
   the pressure-sensitive adhesive/adhesive layer is provided on the low moisture permeable layer on a side opposite to the void-containing layer.

8. The optical laminate according to any one of claims 1 to 7, wherein
   contrast between refractive index $n_a$ of the optical laminate before being held at temperature of 60 °C and relative

humidity of 90 % for 240 hours as a heating and humidifying endurance test and refractive index $n_b$ of the optical laminate after the heating and humidifying endurance test is 0.010 or less.

**9.** The optical laminate according to any one of claims 1 to 8 with a haze value of less than 10 %.

**10.** A method for producing the optical laminate according to any one of claims 1 to 9 comprising:

forming the low moisture permeable layer on a surface of at least one side of the void-containing layer, wherein the low moisture permeable layer is formed by at least one method selected from the group consisting of the vacuum vapor deposition, the sputtering, and the chemical vapor deposition (CVD).

**11.** An optical member comprising:
the optical laminate according to any one of claims 1 to 9.

**12.** An optical apparatus comprising:
the optical member according to claim 11.

**13.** A method for producing the optical member according to claim 11 comprising:
producing the optical laminate according to any one of claims 1 to 9 by the method for producing the optical laminate according to claim 10.

**14.** A method for producing the optical apparatus according to claim 12 comprising:
producing the optical member according to claim 11 by the method for producing the optical member according to claim 13.

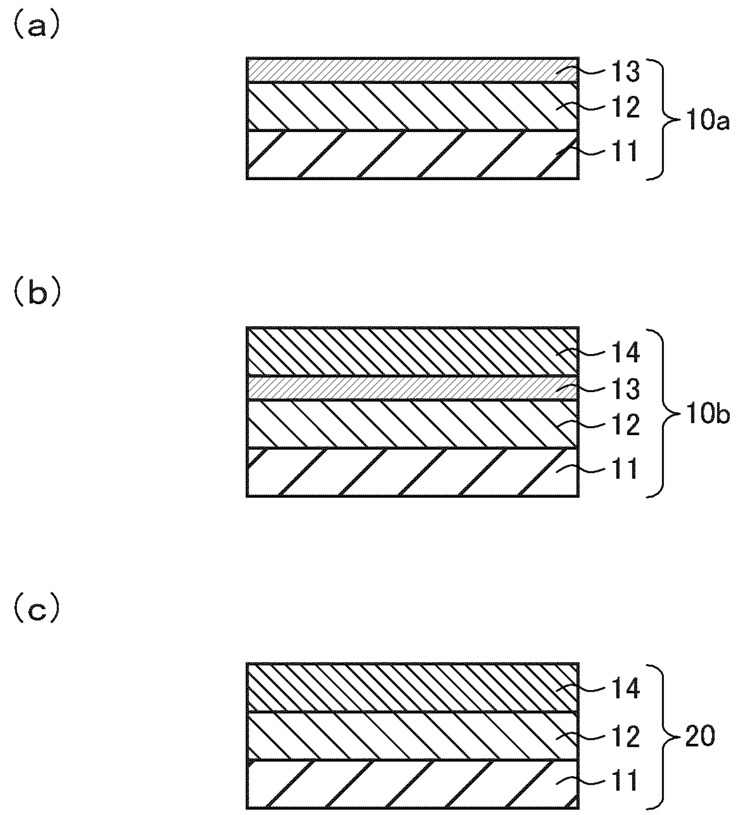
(a)
13
12
11
10a
(b)
14
13
12
11
10b
(c)
14
12
11
20

FIG. 1

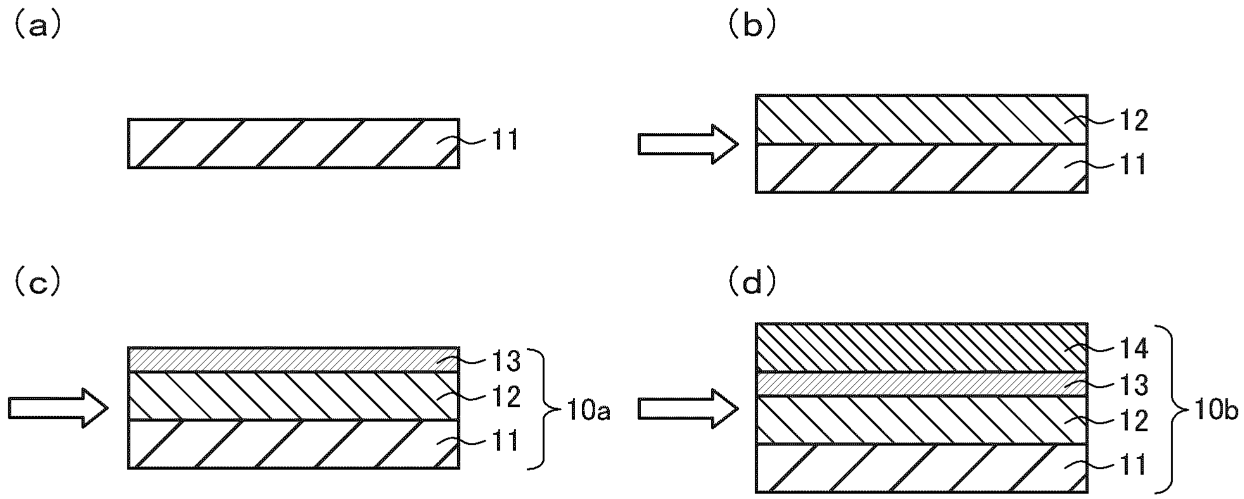
(a)
11
(b)
12
11
(c)
13
12
11
10a
(d)
14
13
12
11
10b

FIG. 2

**INTERNATIONAL SEARCH REPORT**

International application No. **PCT/JP2021/049011**

**A. CLASSIFICATION OF SUBJECT MATTER**

***B32B 5/18***(2006.01)i; ***B32B 9/00***(2006.01)i; ***C01B 33/155***(2006.01)i; ***C23C 14/06***(2006.01)i; ***C23C 14/34***(2006.01)i
FI: B32B5/18; C23C14/34; C01B33/155; B32B9/00 A; C23C14/06 M

According to International Patent Classification (IPC) or to both national classification and IPC

**B. FIELDS SEARCHED**

Minimum documentation searched (classification system followed by classification symbols)

B32B5/00 - 5/32; B32B9/00 - 9/06; G02B1/00 - 1/18; G02B5/00 - 5/32; C23C14/00 - 14/58; C01B33/113 - 33/159

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | JP 2019-064259 A (NITTO DENKO CORP) 25 April 2019 (2019-04-25) paragraphs [0001], [0013], [0031]-[0075], [0214], fig. 1 | 1-14 |
| A | JP 2019-065133 A (NITTO DENKO CORP) 25 April 2019 (2019-04-25) paragraphs [0001], [0015], [0023]-[0063], [0182], fig. 1 | 1-14 |
| A | JP 2017-068248 A (NITTO DENKO CORP) 06 April 2017 (2017-04-06) paragraphs [0001], [0005], [0034]-[0035], [0039]-[0040], [0105] | 1-14 |
| A | JP 2010-272515 A (FUJIFILM CORP) 02 December 2010 (2010-12-02) paragraphs [0041]-[0047], [0068], [0079], fig. 5 | 1-14 |
| A | JP 2010-113310 A (KEIO GIJUKU) 20 May 2010 (2010-05-20) paragraphs [0024], [0029], [0038]-[0041], fig. 1 | 1-14 |
| E, A | JP 2022-019686 A (DEXERIALS CORP) 27 January 2022 (2022-01-27) paragraphs [0001], [0026]-[0028], [0057]-[0080], fig. 1-3 | 1-14 |

☐ Further documents are listed in the continuation of Box C. ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **28 February 2022** | **08 March 2022** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (January 2015)

**INTERNATIONAL SEARCH REPORT**
**Information on patent family members**

International application No.
**PCT/JP2021/049011**

| Patent document cited in search report | Publication date (day/month/year) | Patent family member(s) | Publication date (day/month/year) |
|---|---|---|---|
| JP 2019-064259 A | 25 April 2019 | US 2020/0223175 A1<br>paragraphs [0001], [0018], [0038]-[0089], [0231], fig. 1<br>WO 2019/065999 A1<br>EP 3686006 A1<br>TW 201922477 A<br>CN 111183031 A<br>KR 10-2020-0062221 A | |
| JP 2019-065133 A | 25 April 2019 | US 2020/0224059 A1<br>paragraphs [0001], [0016], [0029]-[0078], [0203], fig. 1<br>US 2020/0233122 A1<br>WO 2019/065803 A1<br>EP 3689953 A1<br>TW 201930424 A<br>KR 10-2020-0040895 A<br>CN 111164140 A | |
| JP 2017-068248 A | 06 April 2017 | (Family: none) | |
| JP 2010-272515 A | 02 December 2010 | WO 2010/123133 A1<br>p. 1, lines 5-8, p. 21, line 24 to p. 24, line 15, p. 33, lines 16-22, p. 39, line 13 to p. 40, line 4, fig. 5 | |
| JP 2010-113310 A | 20 May 2010 | (Family: none) | |
| JP 2022-019686 A | 27 January 2022 | (Family: none) | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2012156082 A
- JP H10199862626 A
- JP 2014046518 A
- WO 2019065999 A
- WO 2019065803 A
- JP 2021058829 A